# EUROPÄISCHE PATENTSCHRIFT

(11) **EP 2 846 145 B1**
(45) Veröffentlichungstag und Bekanntmachung des Hinweises auf die Patenterteilung: **17.06.2020**
(21) Anmeldenummer: 14002973.7
(22) Anmeldetag: 28.08.2014
(51) Int. Cl.: G01M 5/00

(54) **Strukturüberwachungssystem für einen Werkstoff und Herstellungsverfahrensverfahren**
Structural monitoring system for a material and method for manufacturing it
Système de surveillance de structure pour un matériau et procédé de fabrication

(30) Priorität: 10.09.2013 DE 102013014822
(43) Veröffentlichungstag der Anmeldung: 11.03.2015
(73) Patentinhaber: Airbus Defence and Space GmbH, 85521 Ottobrunn (DE)
(72) Erfinder: Lenczowski, Blanka, 85579 Neubiberg (DE)
(74) Vertreter: LKGLOBAL Lorenz & Kopf PartG mbB Patentanwälte

(56) Entgegenhaltungen:
- EP-A1- 2 431 412
- WO-A2-2011/094347
- US-A1- 2005 284 232
- US-A1- 2011 089 958
- US-A1- 2011 142 091
- Anonymous: "Chapter 4 - Aircraft Basic Construction", , 8 May 2003 (2003-05-08), XP055606574, Retrieved from the Internet: URL:http://home.iitk.ac.in/~mohite/Basic_c onstruction.pdf [retrieved on 2019-07-17]

## Beschreibung

### Gebiet der Erfindung

Die Erfindung betrifft einen Werkstoff mit einem Strukturüberwachungssystem

### Hintergrund der Erfindung

Die Eigenschaften von Werkstoffen, welche in einem komplexen übergeordneten Gesamtgebilde zum Einsatz kommen, können einer Überwachung ausgesetzt sein, beispielsweise um einen regelmäßig wiederkehrenden Überblick über die Eigenschaften des überwachten Werkstoffs zu erhalten. Insbesondere können die mechanischen und physikalischen Eigenschaften eines Werkstoffs, wie z.B. die Festigkeit, Restfestigkeit, Ermüdung, E-Mudul das Ziel solcher Strukturüberwachungsmaßnahmen sein.

Strukturüberwachungssysteme dienen der Überwachung der Eigenschaften, insbesondere der mechanischen Eigenschaften, eines Werkstoffs. Eine permanente Strukturüberwachung bei komplexen Systemen, welche hohen Belastungen sowie hohen Sicherheitsanforderungen ausgesetzt sind, beispielsweise von Flugzeugstrukturen, kann zu einer flexiblen Anpassung eines Wartungszyklus dieser komplexen Systeme beitragen und so zu einer verlängerten Lebensdauer und erhöhten Zuverlässigkeit solcher Werkstoffe beitragen.

Eine bekannte Strukturüberwachungsvorrichtung arbeitet mit Ultraschall. Hierbei werden Ultraschallköpfe nachträglich an einem Bauteil mittels einer Klebeverbindung montiert. Der reflektierte Ultraschall kann in Abhängigkeit der Struktur eines Werkstoffs variieren, was beispielsweise Rückschlüsse auf Rissen oder andere mechanische Schäden in der Struktur des geprüften Werkstoffs zulässt.

Bei metallischen Strukturen, wie z.B. Komponenten von Flugzeugen oder von industriellen Anlagen können neben akustischen auch optischen Strukturprüfverfahren eingesetzt werden.

US 2011/0142091 A1 beschreibt das Bestimmen von mechanischen Eigenschaften von strukturellen Elementen. Verformungen oder Risse können dadurch bestimmt werden, dass die thermische oder elektrische Leitfähigkeit von einem Verbund aus Kohlenstoffnanoröhren, der mit einem zu überwachenden Strukturelement gekoppelt ist, ermittelt wird.

### Zusammenfassung der Erfindung

Werden Strukturüberwachungssysteme als zusätzliche Applikationen auf einen Werkstoff aufgetragen, kann dies zu zusätzlichem Gewicht führen, was je nach Anwendungsgebiet des Werkstoffs unerwünscht sein kann.

Bei auf einem Werkstoff aufgeklebten Ultraschallköpfen kann beispielsweise die Klebefuge eine Schwachstelle bilden, insbesondere wenn erhebliche Umweltlasten wie Temperaturwechsel oder mechanische Belastungen wie Dehnungen oder Vibrationen auftreten, was sowohl die Ultraschallköpfe als auch die Klebestelle stark belasten kann.

Solche Ultraschallköpfe können den Nachteil haben, dass sie auf Grund ihrer Arbeitsweise lediglich eine begrenzte lokale Überprüfung des Werkstoffs zulassen.

Es kann als Aufgabe der Erfindung betrachtet werden, einen Werkstoff mit einem Strukturüberwachungssystem bereitzustellen, wobei das Strukturüberwachungssystem ein geringes Gewicht aufweist und eine zuverlässige Überwachung einer Struktur des Werkstoffs ermöglicht. In der Beschreibung wird daneben beispielhaft noch ein Verfahren zum Herstellen eines Werkstoffs mit einem Strukturüberwachungssystem beschrieben, was lediglich dem Verständnis des Aufbaus des Werkstoffs dienen soll.

Diese Aufgabe wird gelöst durch den Gegenstand der Patentansprüche.

Gemäß der Erfindung ist ein Werkstoff mit einem Strukturüberwachungssystem angegeben. Das Strukturüberwachungssystem weist ein Signalübertragungselement und eine Sensoreinheit mit einem Signalgenerator und einem Signalempfänger auf. Die Sensoreinheit ist ausgeführt, ein erstes Signal in das Signalübertragungselement einzuspeisen und ein zweites Signal aus dem Signalübertragungselement als Ergebnis des ersten Signals auszulesen, wobei das zweite Signal dem mit einer Übertragungsfunktion des Signalübertragungselements beaufschlagten ersten Signal entspricht. Der Werkstoff ist ein metallischer Werkstoff. Das Signalübertragungselement weist Kohlenstoffnanoröhren auf und ist in dem metallischen Werkstoff angeordnet. Das Signalübertragungselement ist als Schweißzusatzwerkstoff oder als Pulver-Metallurgie-Vormaterial bei der Herstellung des Werkstoffs eingebracht.

Ein solches Strukturüberwachungssystem kann in tragenden oder unterstützenden Strukturen mit funktionaler Fähigkeit zur Signalübertragung im Rahmen der Strukturüberwachung eingesetzt werden.

Beispielsweise kann das Strukturüberwachungssystem zur Überwachung von industriellen Anlagen, Flugzeugkomponenten, Rohrleitungen oder Komponenten von Windkraftanlagen oder allgemein zur Überwachung von mechanisch beanspruchten oder mechanisch belasteten Komponenten eingesetzt werden.

Die Sensoreinheit weist einen Signalgenerator und einen Signalempfänger aufweisen. Der Signalgenerator ist ausgeführt, ein Signal, beispielsweise ein elektrisches Signal, in das Signalübertragungselement einzuspeisen. Der Signalempfänger ist ausgeführt, das von dem Signalgenerator eingespeiste Signal zu empfangen. In Abhängigkeit des von dem Signalgenerator empfangenen Signals können sodann Rückschlüsse auf Strukturschäden des Werkstoffs gezogen werden.

Das von dem Signalgenerator eingespeiste Signal kann beispielsweise durch strukturelle Schäden wie Risse oder Brüche in dem Signalübertragungselement geändert werden, z.B. indem sich die Amplitude der Signalstärke insgesamt oder auch nur in bestimmten Frequenzbereichen verändert. Aus einer solchen Signal-änderung kann darauf geschlossen werden, in welchem lokalen Bereich und in welchem Umfang das Signalübertragungselement beschädigt ist.

Weil das Signalübertragungselement in einem Werkstoff angeordnet ist, übertragen sich Schäden des Werkstoffs unmittelbar auf das Signalübertragungselement. Somit entsprechen die Schäden des Signalübertragungselementes denen des überwachten Werkstoffs, welche mittels des Strukturüberwachungssystems wie oben und im Folgenden beschrieben festgestellt werden.

In anderen Worten wird also das Signalübertragungselement zur Übertragung eines Signals, insbesondere eines elektrischen oder thermischen Signals, genutzt. Das Signal wird von einem Signalgenerator eingespeist und von einem Signalempfänger empfangen. Abweichungen des empfangenen Signals von dem eingespeisten Signals lassen Schlüsse auf die Struktur bzw. Strukturveränderung des Signalübertragungselementes zu, wobei die Strukturveränderungen des Signalübertragungselementes den Strukturveränderungen bzw. Schäden des Werkstoffs entsprechen.

Das Signalübertragungselement weist Kohlenstoffnanoröhren auf. Diese zeichnen sich durch eine hohe elektrische und thermische Leitfähigkeit aus und können daneben auf Grund ihrer mechanischen Festigkeit zusätzlich die mechanische Belastbarkeit des Werkstoffs erhöhen, an oder in dem sie angebracht sind. Daneben weist Kohlenstoff eine im Vergleich zu beispielsweise Kupfer, Silber oder Diamant geringere Dichte auf und führt damit zu einem geringeren zusätzlichen Gewicht, was insbesondere bei der Überwachung von bzw. Integration in Flugzeugkomponenten vorteilhaft sein kann.

Bei Kohlenstoffnanoröhren handelt es sich um röhrenförmige Gebilde aus Kohlenstoff, deren Durchmesser zwischen wenigen Zehntel Nanometer (nm) bis zu 50 nm betragen kann. Die Länge einer einzelnen Röhre kann bis zu einigen Millimeter (mm) betragen. Mehrere einzelne Röhren können zu Röhrenbündeln zusammengesetzt werden.

Das Signalübertragungselement kann eine Vielzahl von Röhrenbündeln aufweisen, welche beispielsweise netzartig ober wabenförmig aufgebaut sind.

Das Signalübertragungselement kann Kohlenstoff oder Kohlenstoffnanoröhren (Carbon Nanotubes, CNT) aufweisen, welche in Form von Graphenen, Aerographit, CNT-Garn oder sog. Buckypapier bereitgestellt sind.

Bei der Integration in einen Werkstoff ermöglicht das Strukturüberwachungssystem wie oben und im Folgenden beschrieben eine Zustandsüberwachung während der Betriebs- oder Einsatzzeit und ausgehend von sensorischen Elementen über elektronische Komponenten zur Signalverarbeitung bis zur Vernetzung von Teilsystemen und deren Einbindung in komplexe Strukturüberwachungsvorrichtungen, die eine Mehrzahl von Strukturüberwachungssystemen wie oben und im Folgenden beschrieben aufweisen.

Das Strukturüberwachungssystem ermöglicht es, signifikante Strukturverhaltens-änderungen zu detektieren, indem die über das Signalübertragungselement übertragenen Signale einer Auswertung bzw. Bewertung zugeführt werden.

Die Anwendung dieser Strukturüberwachungssysteme für die Überwachung von sicherheitsrelevanten komplexen metallischen Strukturen oder Faserverbundstrukturen während der Einsatzzeit dieser Strukturen kann zu einer starken Verminderung der Wartezeiten bzw. von Leerlauf der überwachten Strukturen bzw. Werkstoffe beitragen und deren Effizienz über die gesamte Lebensdauer bzw. Einsatzzeit durch Schadenfrüherkennung wesentlich steigern.

Es sei darauf hingewiesen, dass das zweite Signal das über das Signalübertragungselement übertragene erste Signal ist. In anderen Worten ist das erste Signal also das Eingangssignal und das zweite Signal das Ausgangssignal.

Gemäß einer Ausführungsform enthalten das erste Signal und das zweite Signal jeweils eine elektrische Signalkomponente, wobei ein Verhältnis des ersten Signals zu dem zweiten Signal herangezogen wird, um eine elektrische Übertragungsfunktion des Signalübertragungselementes zu ermitteln.

Alternativ zu der elektrischen Übertragungsfunktion kann auch die elektrische Leitfähigkeit ermittelt werden. Veränderungen der elektrischen Leitfähigkeit zwischen einem Einspeisungsort und einem Abgreifort des elektrischen Signals weisen auf eine Strukturveränderung des Signalübertragungselementes hin, was als Indiz einer Strukturveränderung des Werkstoffs dient. Materialschäden können somit frühzeitig erkannt werden.

Das erste Signal und das zweite Signal können genutzt werden, um eine Übertragungsfunktion im Zeit- und/oder Frequenzbereich des Signalübertragungselementes zu ermitteln. Veränderungen dieser Übertragungsfunktion im Zeit- und/oder Frequenzbereich deuten auf Strukturveränderungen des Signalübertragungselementes hin.

Gemäß einer weiteren Ausführungsform enthalten das erste Signal und das zweite Signal jeweils eine thermische Signalkomponente, wobei ein Verhältnis des ersten Signals zu dem zweiten Signal herangezogen wird, eine thermische Übertragungsfunktion des Signalübertragungselementes zu ermitteln.

Für die thermische Übertragungsfunktion gelten die Ausführungen zu der elektrischen Übertragungsfunktion analog, mit dem Unterschied dass statt eines elektrischen Signals ein thermisches Signal verwendet wird.

Gemäß einer weiteren Ausführungsform weist das Signalübertragungselement eine Mehrzahl von Übertragungsleitungen bestehend aus Kohlenstoffnanoröhren auf, wobei zumindest eine Übertragungsleitung mit der Sensoreinheit gekoppelt ist.

Ein erster Endabschnitt einer Übertragungsleitung kann mit dem Signalgenerator und ein zweiter Endabschnitt derselben oder einer anderen Übertragungsleitung kann mit dem Signalempfänger gekoppelt sein, wobei der erste Endabschnitt mit dem zweiten Endabschnitt über die Mehrzahl von Übertragungsleitungen gekoppelt ist, so dass das erste Signal über den ersten Endabschnitt eingespeist und das zweite Signal über den zweiten Endabschnitt ausgelesen wird.

Gemäß einer weiteren Ausführungsform kreuzt eine erste Übertragungsleitung eine zweite Übertragungsleitung, so dass das Signalübertragungselement netzartig ausgebildet ist.

Gemäß einem weiteren Aspekt ist ein Werkstoff mit einem Strukturüberwachungssystem wie oben und im Folgenden beschrieben angegeben.

Die Struktur des Werkstoffs kann durch das Anbringen eines Strukturüberwachungssystems überwacht werden, so dass Schäden durch mechanische Belastungen des Werkstoffs oder sogar Strukturveränderungen durch an dem Werkstoff anliegende Kräfte während der Einsatzzeit des Werkstoffs erkannt werden können.

Das Strukturüberwachungssystem kann in den Werkstoff integriert werden.

Die Sensoreinheit mit Signalgenerator und Signalempfänger werden an dem Werkstoff angebracht und mit dem Signalübertragungselement elektrisch und/oder thermisch gekoppelt.

Gemäß einer Ausführungsform ist das Signalübertragungselement in einer Oberflächenschicht des Werkstoffs angeordnet.

In anderen Worten ist das Signalübertragungselement damit in das Material des Werkstoffs integriert. Die Oberflächenschicht kann wenige µm bis zu einigen mm tief sein. Das Signalübertragungselement durchdringt die Oberflächenschicht bzw. verläuft durch diese.

Diese Ausführungsform ermöglicht eine Erkennung von Schäden, welche unter der Oberfläche des Werkstoffs liegen.

Das Signalübertragungselement kann als Füllstoff in Substraten oder Materialien angeordnet sein. Beispielsweise kann das Signalübertragungselement in Hohlräumen, welche in dem Material des Werkstoffs vorkommen, angeordnet sein.

In einer anderen Ausführungsform kann das Signalübertragungselement als zusätzliche Schicht zwischen jeweils zwei aneinandergrenzenden Materiallagen oder Schichten angeordnet sein. Das Signalübertragungselement kann einzeln oder als Mischung, wie z.B. in Form eines Schweißzusatzwerkstoffes zwischen Lagen oder Schichten des Werkstoffs eingewalzt werden.

Gemäß einem Beispiel, das dem Verständnis der Erfindung dient, ist ein Verfahren zum Herstellen eines Werkstoffs wie oben und im Folgenden beschrieben angegeben.

Gemäß der Erfindung ist das Signalübertragungselement als Schweißzusatzwerkstoff oder als Pulver Metallurgie Vormaterial bei der Herstellung des Werkstoffs eingebracht.

Im Folgenden werden mit Bezug zu den Zeichnungen Ausführungsbeispiele der Erfindung beschrieben.

### Kurze Beschreibung der Figuren

Fig. 1 zeigt eine schematische Darstellung eines Strukturüberwachungssystems.
Fig. 2 zeigt eine schematische Darstellung eines Werkstoffs gemäß einem Ausführungsbeispiel.
Fig. 3 zeigt eine schematische Darstellung eines Werkstoffs gemäß einem weiteren Ausführungsbeispiel.
Fig. 4 zeigt eine schematische Darstellung eines Werkstoffs gemäß einem weiteren Ausführungsbeispiel.

Die Darstellungen in den Figuren sind schematisch und nicht maßstabsgetreu. Werden in den folgenden Figuren gleiche Bezugsziffern verwendet, so betreffen diese gleiche oder ähnliche Elemente.

### Detaillierte Beschreibung von Ausführungsbeispielen

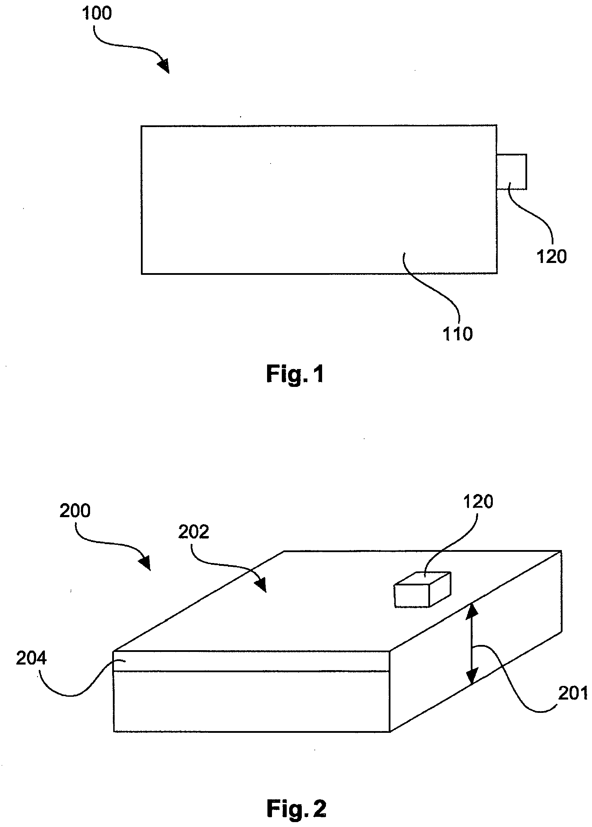

Fig. 1 zeigt ein Strukturüberwachungssystem 100 mit einem Signalübertragungselement 110 und einer Sensoreinheit 120. Die Sensoreinheit 120 ist mit dem Signalübertragungselement 110 gekoppelt, so dass zumindest ein elektrisches und/ oder ein thermisches Signal in das Signalübertragungselement 110 eingespeist und hieraus ausgelesen werden können. Dabei wird das Signal an unterschiedlichen Orten eingespeist und ausgelesen, so dass das Signalübertragungselement mit der Übertragungsfunktion auf das eingespeiste Signal wirkt.

Strukturveränderungen des Signalübertragungselementes 110 bewirken eine Veränderung der Übertragungsfunktion, so dass diese Strukturveränderungen detektiert werden können.

In Fig. 1 ist das Signalübertragungselement der Einfachheit halber als flächiges Element dargestellt.

Das Signalübertragungselement kann eine Vielzahl von Leitungen oder Leitungsabschnitten aufweisen, welche netzartig oder wabenartig miteinander verbunden sind, um so das eingespeiste Signal auf vorgegebenen Wegen zu leiten bzw. zu übertragen. In einem solchen Szenario kann es bei Strukturveränderungen, wie z.B. Rissen, in dem Signalübertragungselement auch zu einer vollständigen Unterbrechung der Signalübertragung kommen.

Fig. 2 zeigt einen Werkstoff 200 mit einer Sensoreinheit 120, welche auf der Oberfläche 202 des Werkstoffs angeordnet ist. Das Signalübertragungselement ist in Fig. 2 aus Veranschaulichungsgründen nicht dargestellt, ist jedoch in der Oberflächenschicht 204 angeordnet.

Die Oberflächenschicht 204 kann eine Dicke oder Tiefe von wenigen mµ bis zu einigen mm aufweisen. Die Sensoreinheit 120 ist mechanisch mit der Oberfläche 202 des Werkstoffs gekoppelt bzw. an der Oberfläche befestigt.

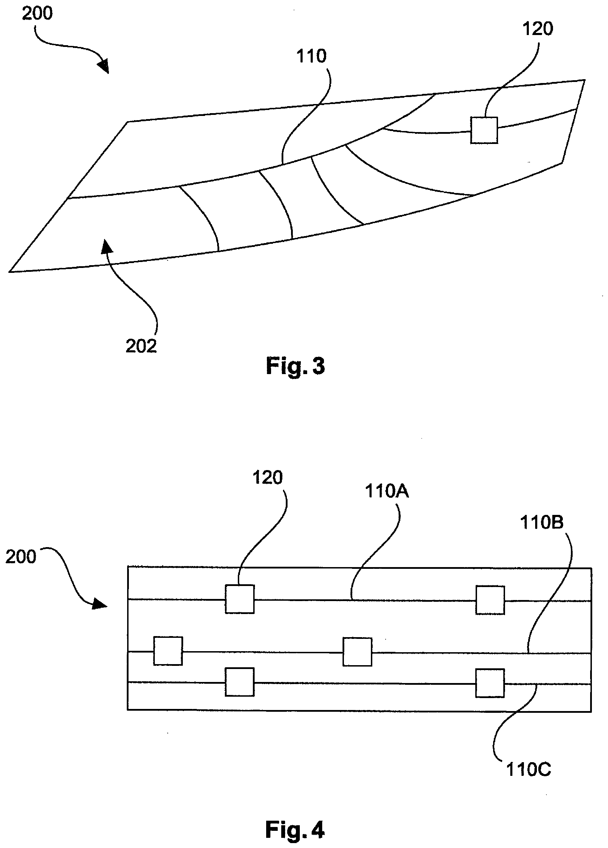

Fig. 3 zeigt einen Werkstoff 200 in Form einer Flugzeugtragfläche, in der das Signalübertragungselement 110 mit mehreren Leiterbahnen bzw. Leiterbahnabschnitten angeordnet ist. Eine Sensoreinheit 120 ist auf der Oberfläche 202 angeordnet und mit einer Leiterbahn des Signalübertragungselements 110 elektrisch und/oder thermisch gekoppelt.

Es sei darauf hingewiesen, dass das Strukturüberwachungssystem eine Mehrzahl von Sensoreinheiten 120 aufweisen kann, welche mit dem Signalübertragungselement 110 gekoppelt sind. Dabei können Signale von einer ersten Sensoreinheit an eine zweite Sensoreinheit übertragen werden. Durch die Anordnung mehrerer Sensoreinheiten an verschiedene Stellen kann die Übertragungsfunktion unterschiedlicher Leiterbahnabschnitte überprüft bzw. überwacht werden, so dass ein ggf. auftretender Strukturdefekt lokalisiert werden kann.

Die Leiterbahnen des Signalübertragungselements 110 können insbesondere an mechanisch hoch beanspruchten Stellen des Werkstoffs angeordnet werden, beispielsweise in einem Bereich mit hohen Oberflächenspannungen oder hohen Biegekräften oder Vibrationsbeanspruchungen.

Fig. 4 zeigt einen Werkstoff 200 mit einem Strukturüberwachungssystem, dessen Signalübertragungselement 110 drei voneinander getrennte Leiterbahnen 110A, 110B, 110C aufweist, wobei an jeder Leiterbahn jeweils zwei Sensoreinheiten 120 angeordnet sind.

Somit kann die Übertragungsfunktion jeder der drei Leiterbahnen gesondert überprüft werden, da eine erste Sensoreinheit ein Signal einspeist, welches von der zweiten Sensoreinheit empfangen und ausgewertet wird.

Das gesendete Signal kann über eine weitere Übertragungsstrecke von der ersten Sensoreinheit an die zweite Sensoreinheit übertragen werden, so dass bei der empfangenden Sensoreinheit die Übertragungsfunktion aus dem tatsächlich gesendeten Signal und dem empfangenen Signal ermittelt werden kann. Alternativ kann eine vorher festgelegte Signalfolge gesendet werden, welche der zweiten Sensoreinheit bekannt ist, so dass die Übertragungsfunktion ohne zusätzliche Übertragung der Sendesignalfolge ermittelt werden kann.

### Bezugszeichenliste

- 100: Strukturüberwachungssystem
- 110: Signalübertragungselement
- 120: Sensoreinheit
- 200: Werkstoff
- 201: Werkstoffdicke
- 202: Oberfläche
- 204: Oberflächenschicht

## Patentansprüche

1. Werkstoff (200) mit einem Strukturüberwachungssystem (100),
wobei das Strukturüberwachungssystem aufweist:
ein Signalübertragungselement (110); und
eine Sensoreinheit (120) mit einem Signalgenerator und einem Signalempfänger;
wobei der Signalgenerator ausgeführt ist, ein erstes Signal in das Signalübertragungselement (110) einzuspeisen,
wobei der Signalempfänger ausgeführt ist, ein zweites Signal aus dem Signalübertragungselement als Ergebnis des ersten Signals auszulesen, wobei das zweite Signal dem mit einer Übertragungsfunktion des Signalübertragungselements (110) beaufschlagten ersten Signal entspricht;
wobei der Werkstoff ein metallischer Werkstoff ist;
wobei das Signalübertragungselement Kohlenstoffnanoröhren aufweist und in dem metallischen Werkstoff angeordnet ist;
**dadurch gekennzeichnet, dass**
das Signalübertragungselement als Schweißzusatzwerkstoff oder als Pulver-Metallurgie-Vormaterial bei der Herstellung des Werkstoffs eingebracht ist.

2. Werkstoff (200) nach Anspruch 1,
wobei das erste Signal und das zweite Signal jeweils eine elektrische Signalkomponente enthalten;
wobei ein Verhältnis des ersten Signals zu dem zweiten Signal herangezogen wird, um eine elektrische Übertragungsfunktion des Signalübertragungselementes zu ermitteln.

3. Werkstoff (200) nach Anspruch 1 oder 2,
wobei das erste Signal und das zweite Signal jeweils eine thermische Signalkomponente enthalten;
wobei ein Verhältnis des ersten Signals zu dem zweiten Signal herangezogen wird, eine thermische Übertragungsfunktion des Signalübertragungselementes zu ermitteln.

4. Werkstoff (200) nach einem der vorhergehenden Ansprüche,
wobei das Signalübertragungselement eine Mehrzahl von Übertragungsleitungen bestehend aus Kohlenstoffnanoröhren aufweist;
wobei zumindest eine Übertragungsleitung mit der Sensoreinheit gekoppelt ist.

5. Werkstoff (200) nach Anspruch 4,
wobei eine erste Übertragungsleitung eine zweite Übertragungsleitung kreuzt, so dass das Signalübertragungselement netzartig ausgebildet ist.

## Claims

1. Material (200) having a structure-monitoring system (100), wherein the structure-monitoring system has:
a signal-transmitting element (110); and
a sensor unit (120) with a signal generator and a signal receiver;
wherein the signal generator is designed to feed a first signal into the signal-transmission element (110),
wherein the signal receiver is designed to read a second signal out of the signal-transmission element as a result of the first signal, wherein the second signal corresponds to the first signal to which a transmission function of the signal-transmission element (110) is applied;
wherein the material is a metallic material;
wherein the signal-transmission element has carbon nanotubes and is arranged in the metallic material;
**characterized in that**
the signal-transmission element is introduced as a weld additive or as a powder metallurgy primary material during the manufacture of the material.

2. Material (200) according to Claim 1,
wherein the first signal and the second signal each contain an electrical signal component;
wherein a ratio of the first signal to the second signal is used to determine an electrical transmission function of the signal-transmission element.

3. Material (200) according to Claim 1 or 2,
wherein the first signal and the second signal each contain a thermal signal component;
wherein a ratio of the first signal to the second signal is used to determine a thermal transmission function of the signal-transmission element.

4. Material (200) according to one of the preceding claims,
wherein the signal-transmission element has a multiplicity of transmission lines composed of carbon nanotubes;
wherein at least one transmission line is coupled to the sensor unit.

5. Material (200) according to Claim 4,
wherein a first transmission line intersects a second transmission line so that the signal-transmission element is embodied in a mesh-like manner.

## Revendications

1. Matériau (200) comprenant un système de surveillance de structure (100), le système de surveillance de structure comportant :
un élément de transmission de signal (110) ; et
une unité de détection (120) dotée d'un générateur de signal et d'un récepteur de signal ;
le générateur de signal étant réalisé pour injecter un premier signal dans l'élément de transmission de signal (110),
le récepteur de signal étant réalisé pour lire un deuxième signal provenant de l'élément de transmission de signal en tant que résultat du premier signal, le deuxième signal correspondant au premier signal auquel a été appliquée une fonction de transmission de l'élément de transmission de signal (110) ;
le matériau étant un matériau métallique ;
l'élément de transmission de signal possédant des nanotubes en carbone et étant disposé dans le matériau métallique ;
**caractérisé en ce que**
l'élément de transmission de signal est incorporé lors de la fabrication du matériau sous la forme d'un métal d'apport de soudage ou d'un produit primaire de la métallurgie des poudres.

2. Matériau (200) selon la revendication 1,
le premier signal et le deuxième signal contenant respectivement une composante de signal électrique ;
un rapport entre le premier signal et le deuxième signal étant utilisé pour déterminer une fonction de transmission électrique de l'élément de transmission de signal.

3. Matériau (200) selon la revendication 1 ou 2,
le premier signal et le deuxième signal contenant respectivement une composante de signal thermique ;
un rapport entre le premier signal et le deuxième signal étant utilisé pour déterminer une fonction de thermique électrique de l'élément de transmission de signal.

4. Matériau (200) selon l'une des revendications précédentes,
l'élément de transmission de signal possédant une pluralité de lignes de transmission constituées de nanotubes en carbone ;
au moins une ligne de transmission étant couplée à l'unité de détection.

5. Matériau (200) selon la revendication 4,
une première ligne de transmission croisant une deuxième ligne de transmission de telle sorte que l'élément de transmission de signal est réalisé à la manière d'un filet.
